# EUROPÄISCHE PATENTSCHRIFT

(11) **EP 0 726 654 B1**
(45) Veröffentlichungstag und Bekanntmachung des Hinweises auf die Patenterteilung: **29.12.1997**
(21) Anmeldenummer: 96101080.8
(22) Anmeldetag: 25.01.1996
(51) Int. Cl.: H03K 17/567

(54) **Integrierbarer Umschalter für höhere Spannungen**
Integrable two-way switch for higher voltages
Commutateur intégrable à tension élevée

(30) Priorität: 10.02.1995 DE 19504480
(43) Veröffentlichungstag der Anmeldung: 14.08.1996
(73) Patentinhaber: SIEMENS AKTIENGESELLSCHAFT, 80333 München (DE)
(72) Erfinder: Zojer, Bernhard, Dipl.-Ing., A-9500 Villach (AT)

(56) Entgegenhaltungen:
- EP-A- 0 314 221
- US-A- 5 023 493

## Beschreibung

Die Erfindung betrifft einen integrierbaren Umschalter zum wahlweise Aufschalten eines Bezugspotentials oder eines demgegenüber positiven Versorgungspotentials auf einen Anschluß einer über den anderen Anschluß mit einem gegenüber dem Bezugspotential negativen Versorgungspotential verbundenen Last.

Beispielsweise beim Betrieb von integrierten Leitungsanpaßschaltungen in Telefonnetzen ist es notwendig, die zur Versorgung der Anpaßschaltung erforderliche Spannung zwischen zwei unterschiedlichen Werten umzuschalten. Hierzu ist ein Anschluß des Schaltkreises fest mit einem Pol - meistens dem negativen Pol - einer Batterie verbunden, während der andere Anschluß entweder auf den anderen (positiven) Pol der Batterie oder durch Verbinden mit Masse auf eine demgegenüber kleinere Spannung - meistens die halbe Batteriespannung - aufgeschaltet wird. Die Batterie bildet demnach zusammen mit Masse eine bipolare Spannungsversorgung, die beispielsweise zwei gegenüber Masse symmetrische Spannungen von ± 80 V erzeugt, wobei je nach Schaltzustand des Umschalters am integrierten Schaltkreis 80 V oder 160 V anliegen.

Um den externen Schaltungsaufwand möglichst gering zu halten, wird angestrebt, den Umschalter im allgemeinen zu integrieren und insbesondere in die Anpaßschaltung selbst mit zu integrieren. Dabei soll der integrierte Umschalter einen geringen Innenwiderstand und damit geringen Spannungsabfall, eine hohe Spannungsfestigkeit verbunden mit einer geringen Empfindlichkeit gegen Überspannungen sowie ein vernachlässigbares Speicherverhalten aufweisen.

Aufgabe der Erfindung ist es, einen für höhere Spannungen geeigneten, integrierbaren Umschalter der eingangs genannten Art anzugeben, der diese Anforderungen erfüllt.

Die Aufgabe wird gelöst durch einen integrierbaren Umschalter mit einem ersten Schaltmittel, das einerseits an das positive Versorgungspotential und andererseits an den einen Lastanschluß angeschlossen ist, und mit einem ein zweites Schaltmittel bildenden DMOS-Feldeffekttransistor vom n-Kanal-Typ, dessen Sourceanschluß an das Bezugspotential angeschlossen ist, dessen Drainanschluß mit dem einen Lastanschluß verbunden ist und an dessen Gateanschluß zum Erzeugen des sperrenden Schaltzustandes das Bezugspotential und zum Erzeugen des leitenden Schaltzustandes ein gegenüber dem Bezugspotential positives Steuerpotential angelegt wird und dessen Durchlaßwiderstand so klein ist, daß bei maximalem Source-Drain-Strom die abfallende Source-Drain-Spannung geringer bleibt als die Basis-Emitter-Schwellspannung des durch Bulk-, Drain- und Substratanschluß des Feldeffekttransistors gebildeten parasitären Bipolartransistors vom pnp-Typ, wobei die einander entsprechenden Schaltzustände beider Schaltmittels jeweils entgegengesetzt zueinander auftreten.

Bei einer Weiterbildung der Erfindung ist es vorgesehen, daß das erste Schaltmittel durch einen Bipolartransistor vom npn-Typ gebildet wird, dessen Kollektoranschluß mit dem positiven Versorgungspotential verbunden ist, dessen Emitteranschluß mit dem einen Lastanschluß gekoppelt ist und an dessen Basisanschluß zur Erzeugung des leitenden Schaltzustandes ein gegenüber dem Bezugspotential positives Steuerpotential und zur Erzeugung des sperrenden Schaltzustandes ein gegenüber dem Bezugspotential negatives Steuerpotential angelegt ist.

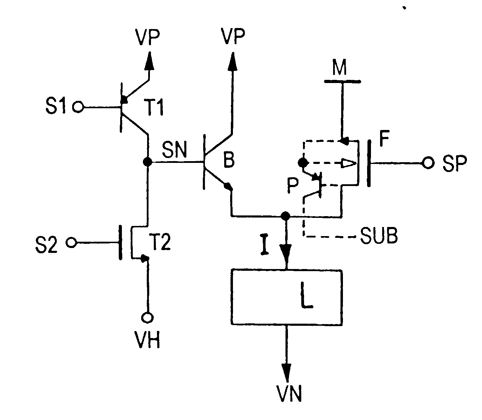

Die Erfindung wird nachfolgend anhand des in der einzigen Figur der Zeichnung dargestellten Ausführungsbeispiels näher erläutert.

Der als Ausführungsbeispiel gezeigte integrierbare Umschalter besteht zum einen aus einem DMOS-Feldeffekttransistor F vom n-Kanal-Typ, dessen Sourceanschluß an ein Bezugspotential M angeschlossen ist und an dessen Gateanschluß ein Steuersignal SP angelegt ist. Zum anderen ist ein Bipolartransistor B vom npn-Typ vorgesehen, dessen Kollektoranschluß mit einem positiven Versorgungspotential VP verbunden ist und an dessen Basisanschluß ein Steuersignal SN angelegt ist. Der Emitteranschluß des Bipolartransistors B und der Drainanschluß des Feldeffekttransistors F sind miteinander gekoppelt und bilden den Schaltausgang des Umschalters. Zwischen den Schaltausgang und ein negatives Versorgungspotential VN ist eine Last L geschaltet, die beispielsweise aus einem integrierten Schaltkreis besteht. Die Last L nimmt einen Strom I auf, der höchstens den Wert Iₘₐₓ annehmen kann.

Die Steuersignale SP und SN führen entsprechend den beiden Schaltzuständen des Feldeffekttransistors F und des Bipolartransistors B jeweils zwei unterschiedliche Steuerpotentiale. Das Steuersignal SP nimmt zur Erzeugung des sperrenden Schaltzustandes einen zum vollständigen Sperren ausreichenden Wert in der Nähe des Bezugspotentials M an. Zum Erzeugen des leitenden Schaltzustandes führt es ein gegenüber dem Bezugspotential M derart positives Potential, daß bei maximalem Source-Drain-Strom die abfallende Source-Drain-Spannung am dementsprechend ausgestalteten Feldeffekttransistor F geringer bleibt als die Basis-Emitter-Schwellspannung des durch Bulk-, Drain- und Substratanschluß SUB des Feldeffekttransistors F gebildeten parasitären Bipolartransistors P vom pnp-Typ.

Um den Bipolartransistor B möglichst vollständig durchzusteuern, führt das Steuersignal SN zur Erzeugung des leitenden Schaltzustandes ein ausreichend positives Potential, das beispielsweise nahe am positiven Versorgungspotential VP liegt. Zur Erzeugung des sperrenden Schaltzustandes wird durch das Steuersignal SN ein gegenüber dem Bezugspotential M negatives Potential angelegt. Die Steuersignale SP und SN sind derart aufeinander abgestimmt, daß der eine Transistor leitet, wenn der andere sperrt, und umgekehrt.

Der Umschalter besteht somit aus zwei invers zueinander gesteuerten Ein-Aus-Schaltern, von denen der eine zwischen Last L und Bezugspotential M und der andere zwischen Last L und positivem Versorgungspotential VP geschaltet ist. Der Schalter zwischen Last L und Bezugspotential M wird dabei durch den im eingeschalteten Zustand invers betriebenen DMOS-Feldeffekttransistor F gebildet. Der Kanal des Feldeffekttransistors muß dabei so groß gewählt werden, daß an dem Kanalwiderstand im leitenden Zustand des Feldeffekttransistors bei maximalem Source-Drain-Strom eine Spannung abfällt, die kleiner bleibt als die Diodenschwelle der Basis-Emitter-Diode des parasitären Transistors P. Als Steuersignal SP kann daher ein Logiksignal verwendet werden, das bei leitendem Feldeffekttransistor F ein positives Potential von 5 V gegenüber dem Bezugspotential M führt und das bei sperrendem Feldeffekttransistor F in etwa gleich dem Bezugspotential M ist.

Bei dem zwischen der Last L und dem positiven Versorgungspotential VP liegenden Schalter wäre üblicherweise ein Bipolartransistor erforderlich, der bei einer Ansteuerung mit Potentialen gleich oder größer dem Bezugspotential M eine Durchbruchspannung zwischen Kollektor und Emitter aufweist, die größer ist als die Differenz von positivem Versorgungspotential VP und dem Bezugspotential M. Dies trifft jedoch häufig nicht zu. Allerdings ist bei den meisten Transistoren die Durchbruchspannung zwischen Kollektor und Basis deutlich höher als die Durchbruchspannung zwischen Kollektor und Emitter. Diese Eigenschaft wird vorliegend dadurch ausgenutzt, daß im ausgeschalteten Zustand die Basis des Bipolartransistors B mit einem gegenüber dem Bezugspotential M negativen Potential beaufschlagt wird, während der Emitter in etwa auf dem Bezugspotential M infolge des leitenden Feldeffekttransistors F gehalten wird. Für die Durchbruchsfestigkeit ist in diesem Fall die Durchbruchspannung zwischen Kollektor und Basis des Bipolartransistors B relevant. Die Durchbruchsfestigkeit des Schalters zwischen der Last L und dem positiven Versorgungspotential VP wird dadurch insgesamt erhöht. Bei üblichen Versorgungspotentialen von +80 V bzw. - 80 V führt das Steuersignal SN beispielsweise im Leitzustand des Bipolartransistors B ein Potential von +80 V und im sperrenden Zustand von -5 V gegenüber dem Bezugspotential M.

Die Werte hängen allerdings sowohl beim Bipolartransistor B als auch beim Feldeffekttransistor F von der jeweiligen Dimensionierung und dem jeweiligen Anwendungsfall ab und sind dementsprechend anzupassen. Die Verwendung von npn- bzw. n-Kanal-Transistoren hat dabei den Vorteil, daß der jeweilige Durchgangswiderstand geringer ist als bei vergleichbaren pnp-bzw. p-Kanal-Transistoren.

Schließlich ist bei dem Ausführungsbeispiel eine Anordnung zur Erzeugung des Steuersignals SN gezeigt. Dabei ist ein Bipolartransistor T1 vom pnp-Typ über seinen Emitteranschluß mit dem positiven Versorgungspotential VP und über seinen Kollektoranschluß mit dem Basisanschluß des Bipolartransistors B verbunden. Ein DMOS-Feldeffekttransistor T2 vom p-Kanal-Typ ist über seinen Drainanschluß mit dem Basisanschluß des Bipolartransistors B und über seinen Sourceanschluß mit einem gegenüber dem Bezugspotential M negativen Hilfspotential VH gekoppelt. Über Steuersignale S1 und S2, die an dem Basisanschluß des Bipolartransistors T1 bzw. an dem Gateanschluß des Feldeffekttransistors T2 angelegt sind, werden die Transistoren T1 und T2 komplementär angesteuert und legen entweder annähernd das positive Versorgungspotential VP oder annähernd das negative Hilfspotential VH an den Basisanschluß des Bipolartransistors B. Gemäß den obigen Dimensionierungsbeispielen ist demnach das positive Versorgungspotential VP gleich +80 V und das negative Hilfspotential VH gleich -5 V zu setzen.

## Patentansprüche

1. Integrierbarer Umschalter zum wahlweise Aufschalten eines Bezugspotentials (M) oder eines demgegenüber positiven Versorgungspotentials (VP) auf einen Anschluß einer über den anderen Anschluß mit einem gegenüber dem Bezugspotential (M) negativen Versorgungspotential (VN) verbundenen Last (L), mit einem ersten Schaltmittel (B), das einerseits an das positive Versorgungspotential (VP) und andererseits an den einen Lastanschluß (L) angeschlossen ist, und
mit einem ein zweites Schaltmittel bildenden DMOS-Feldeffekttransistor (F) vom n-Kanal-Typ, dessen Sourceanschluß an das Bezugspotential (M) angeschlossen ist, dessen Drainanschluß mit dem einen Lastanschluß (L) verbunden ist, an dessen Gateanschluß zum Erzeugen des sperrenden Schaltzustandes annähernd das Bezugspotential (M) und zum Erzeugen des leitenden Schaltzustandes ein gegenüber dem Bezugspotential (M) positives Steuerpotential (SP) angelegt wird und dessen Durchlaßwiderstand so klein ist, daß bei maximalem Source-Drain-Strom die abfallende Source-Drain-Spannung geringer bleibt als die Basis-Emitter-Schwellspannung des durch Bulk-, Drain- und Substratanschluß (SUB) des Feldeffekttransistors (F) gebildeten parasitären Bipolartransistors (B) vom pnp-Typ, wobei die Schaltzustände beider Schaltmittel (B, F) jeweils entgegengesetzt zueinander auftreten.

2. Umschalter nach Anspruch 1, **dadurch gekennzeichnet**, daß das erste Schaltmittel durch einen Bipolartransistor (B) vom npn-Typ gebildet wird, dessen Kollektoranschluß mit dem positiven Versorgungspotential (VP) verbunden ist, dessen Emitteranschluß mit dem einen Lastanschluß (L) gekoppelt ist und an dessen Basisanschluß zur Erzeugung des leitenden Schaltzustandes ein gegenüber dem Bezugspotential (M) positives Steuerpotential (VN) und zur Erzeugung des sperrenden Schaltzustandes ein gegenüber dem Bezugspotential (M) negatives Steuerpotential (SN) angelegt ist.

## Claims

1. Integrable changeover switch for optionally connecting a reference potential (M) , or a supply potential (VP) which is positive with respect thereto, to one terminal of a load (L) which is connected via the other terminal to a supply potential (VN) which is negative with respect to the reference potential (M), having a first switching means (B) which is connected, on the one hand, to the positive supply potential (VP) and, on the other hand, to the one load terminal (L), and having a DMOS field-effect transistor (F), forming a second switching means, of n-channel type whose source terminal is connected to the reference potential (M), whose drain terminal is connected to the one load terminal (L), to whose gate terminal approximately the reference potential (M) is applied for the purpose of producing the locking switching state, and a control potential (SP) which is positive with respect to the reference potential (M) is applied for the purpose of producing the conducting switching state, and whose forward resistance is so small that in the case of maximum source-drain current the falling source-drain voltage remains lower than the base-emitter threshold voltage of the parasitic bipolar transistor (B) of pnp type, which is formed by the bulk, drain and substrate terminal (SUB) of the field-effect transistor (F), the switching states of the two switching means (B, F) respectively occurring in opposition to one another.

2. Changeover switch according to Claim 1, characterized in that the first switching means is formed by a bipolar transistor (B) of npn type, whose collector terminal is connected to the positive supply potential (VP), whose emitter terminal is coupled to one load terminal (L), and to whose base terminal a control potential (VN) which is positive with respect to the reference potential (M) is applied for the purpose of producing the conducting switching state, and a control potential (SN) which is negative with respect to the reference potential (M) is applied for the purpose of producing the blocking switching state.

## Revendications

1. Commutateur intégrable servant à appliquer sélectivement un potentiel de référence (M) ou un potentiel d'alimentation (VP) positif par rapport à celui-ci, à une connexion d'une charge (L) connectée par l'autre connexion à un potentiel d'alimentation (VN) négatif par rapport au potentiel de référence (M) comprenant un premier moyen de commutation (B) qui est connecté, d'une part, au potentiel d'alimentation positif (VP) et, d'autre part, à une connexion (L) de la charge, et qui est raccordé à un transistor à effet de champ DMOS (F) à canal du type n formant un deuxième moyen de commutation, dont la connexion de source est connectée au potentiel de référence (M), dont la connexion de drain est connectée à une des connexions de la charge (L), à la connexion de grille duquel est appliqué approximativement le potentiel de référence (M) pour générer l'état de commutation bloqué et un potentiel de commande (SP) positif par rapport au potentiel de référence (M) pour générer l'état de commutation conducteur, et dont la résistance directe de passage est suffisamment petite pour qu'en présence du courant source-drain maximum, la différence de potentiel source-drain qui s'établit reste inférieure à la tension de seuil base-émetteur du transistor bipolaire parasite (B) du type pnp formé par la connexion Bulk, drain et substrat (SUB) du transistor à effet de champ (F), les états de commutation des deux moyens de commutation (B, F) se produisant à chaque fois l'un à l'inverse de l'autre.

2. Commutateur selon la revendication 1, caractérisé en ce que le premier moyen de commutation est formé par un transistor bipolaire (B) du type npn dont la connexion de collecteur est connectée au potentiel d'alimentation positif (VP), dont la connexion d'émetteur est couplée à l'une des connexions de la charge (L), et à la connexion de base duquel un potentiel de commande (VN) positif par rapport au potentiel de référence (M) est appliqué pour produire l'état de commutation conducteur et un potentiel de commande (SN) négatif par rapport au potentiel de référence (M) est appliqué pour produire l'état de commutation bloqué.
